(19) Europäisches Patentamt / European Patent Office / Office européen des brevets

(11) **EP 3 298 419 B1**

(12) **FASCICULE DE BREVET EUROPEEN**

(45) Date de publication et mention de la délivrance du brevet:
**23.03.2022 Bulletin 2022/12**

(21) Numéro de dépôt: **16722184.5**

(22) Date de dépôt: **11.05.2016**

(51) Classification Internationale des Brevets (IPC):
**G01R 31/11** *(2006.01)* **H04B 3/46** *(2015.01)*

(52) Classification Coopérative des Brevets (CPC):
**G01R 31/11; H04B 3/46**

(86) Numéro de dépôt international:
**PCT/EP2016/060489**

(87) Numéro de publication internationale:
**WO 2016/188740 (01.12.2016 Gazette 2016/48)**

(54) **PROCEDE D'ANALYSE D'UN CABLE, IMPLIQUANT UN TRAITEMENT D'AMPLIFICATION DE LA SIGNATURE D'UN DEFAUT NON FRANC**

VERFAHREN ZUR ANALYSE EINES KABELS MIT EINEM VERARBEITUNGSVORGANG ZUR VERSTÄRKUNG DER SIGNATUR EINES LEICHTEN FEHLERS

METHOD FOR ANALYSING A CABLE, INVOLVING A PROCESSING OPERATION AMPLIFYING THE SIGNATURE OF A SOFT FAULT

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **22.05.2015 FR 1554632**

(43) Date de publication de la demande:
**28.03.2018 Bulletin 2018/13**

(73) Titulaire: **Commissariat à l'Énergie Atomique et aux Énergies Alternatives**
**75015 Paris (FR)**

(72) Inventeur: **SALLEM, Soumaya**
**60180 Nogent sur Oise (FR)**

(74) Mandataire: **Marks & Clerk France**
**Immeuble "Visium"**
**22, avenue Aristide Briand**
**94117 Arcueil Cedex (FR)**

(56) Documents cités:
FR-A1- 2 946 149     FR-A1- 2 981 752
US-A1- 2004 230 387

- SOUMAYA SALLEM ET AL: "JOINT SELF-ADAPTIVE CORRELATION METHOD AND MODIFIED EMPIRICAL MODE DECOMPOSITION FOR SOFT DEFECT DETECTION IN CABLE BY REFLECTOMETRY", PROGRESS IN ELECTROMAGNETICS RESEARCH LETTERS, vol. 51, 1 janvier 2015 (2015-01-01), pages 47-52, XP055264824, DOI: 10.2528/PIERL14120503
- L.A GRIFFITHS ET AL: "The invisible fray: a critical analysis of the use of reflectometry for fray location", IEEE SENSORS JOURNAL., vol. 6, no. 3, 1 juin 2006 (2006-06-01), pages 697-706, XP055264795, US ISSN: 1530-437X, DOI: 10.1109/JSEN.2006.874017

**Description**

L'invention concerne un procédé et un système de réflectométrie pour détecter et localiser des défauts non francs dans un câble. Le domaine de l'invention est celui des systèmes de diagnostic filaires basés sur le principe de la réflectométrie.

Les câbles sont omniprésents dans tous les systèmes électriques, pour l'alimentation ou la transmission d'information. Ces câbles sont soumis aux mêmes contraintes que les systèmes qu'ils relient et peuvent être sujets à des défaillances. Il est donc nécessaire de pouvoir analyser leur état et d'apporter des informations sur la détection de défauts, mais aussi leur localisation et leur type, afin d'aider à la maintenance. Les méthodes de réflectométrie usuelles permettent ce type de tests.

Les méthodes de réflectométrie utilisent un principe proche de celui du radar : un signal électrique, le signal de sonde, souvent de haute fréquence ou large bande, est injecté en un ou plusieurs endroits du câble à tester. Ledit signal se propage dans le câble ou le réseau et renvoie une partie de son énergie lorsqu'il rencontre une discontinuité électrique. Une discontinuité électrique peut résulter, par exemple, d'un branchement, de la fin du câble ou d'un défaut ou plus généralement d'une rupture des conditions de propagation du signal dans le câble. Elle résulte le plus souvent d'un défaut qui modifie localement l'impédance caractéristique du câble en provoquant une discontinuité dans ses paramètres linéiques.

L'analyse des signaux renvoyés au point d'injection permet d'en déduire des informations sur la présence et la localisation de ces discontinuités, donc des défauts éventuels. Une analyse dans le domaine temporel ou fréquentiel est habituellement réalisée. Ces méthodes sont désignées par les acronymes TDR venant de l'expression anglo-saxonne « Time Domain Reflectometry » et FDR venant de l'expression anglo-saxonne « Frequency Domain Reflectometry ».

L'invention s'applique à tout type de câble électrique, en particulier des câbles de transmission d'énergie ou des câbles de communication, dans des installations fixes ou mobiles. Les câbles concernés peuvent être coaxiaux, bifilaires, en lignes parallèles, en paires torsadées ou autre pourvu qu'il soit possible d'y injecter un signal de réflectométrie et de mesurer sa réflexion.

Les méthodes de réflectométrie temporelle connues sont particulièrement adaptées à la détection de défauts francs dans un câble, tel un court circuit ou un circuit ouvert ou plus généralement une modification locale significative de l'impédance du câble. La détection du défaut se fait par la mesure de l'amplitude du signal réfléchi sur ce défaut qui est d'autant plus importante et donc détectable, que le défaut est franc.

A l'inverse, un défaut non franc, par exemple résultant d'une dégradation superficielle de la gaine du câble de l'isolant ou du conducteur, engendre un pic d'amplitude faible sur le signal de réflectométrie réfléchi et est par conséquent plus difficilement détectable par des méthodes temporelles classiques.

La détection et la localisation d'un défaut non franc sur un câble est un problème important pour le monde industriel car un défaut apparait en général d'abord comme un défaut superficiel mais peut, avec le temps, évoluer vers un défaut plus impactant. Pour cette raison notamment, il est utile de pouvoir détecter l'apparition d'un défaut dès son apparition et à un stade où son impact est superficiel afin d'anticiper son évolution en un défaut plus important.

Les méthodes connues permettant l'identification de défauts non francs sur un câble sont le plus souvent des méthodes de réflectométrie temps-fréquence. Ces méthodes ont été développées afin de permettre une meilleure mise en évidence des signaux réfléchis de faible amplitude.

On connait notamment la méthode « Joint Time-Frequency Domain Reflectometry » décrite dans le document Y. J. Shin. "Theory and Application of Time-Frequency Analysis to Transient Phenomena", in Electric Power and Other Physical Systems. PhD thesis, University of Texas, 2004 qui propose l'utilisation de la transformée fréquentielle de Wigner-Ville. Cette méthode permet une meilleure discrimination des réflexions de signal sur des défauts non francs avec une bonne résolution temporelle et fréquentielle. Cependant, elle présente le double inconvénient d'être complexe à implémenter dans un système embarqué et induit des problèmes de fausse détection dus à l'existence de termes croisés dans la transformée précitée.

La demande de brevet français du Demandeur publiée sous le numéro FR 2981752 propose un perfectionnement de la méthode temps-fréquence décrite dans le document précidé de Y.J.Shin, qui permet d'éliminer l'influence des termes croisés et de supprimer les problèmes de fausse détection.

Cependant cette méthode présente toujours l'inconvénient d'une complexité importante de mise en œuvre pour des équipements portatifs.

On connait également la méthode décrite dans la demande de brevet français du Demandeur publiée sous le numéro FR 2946149.

L'invention propose une méthode d'analyse d'un câble en vue de la détection de défauts non francs qui remédie aux limitations des solutions de l'art antérieur. L'invention permet une amplification de la signature des défauts non francs sans amplification conjointe du bruit. Pour obtenir ce résultat, la méthode est basée sur une identification des zones du signal correspondant à des signatures de défauts potentiels puis à l'application d'une fonction particulière de traitement de signal sur ces zones pour amplifier les signatures de faible amplitude sans amplifier le bruit.

La méthode proposée est faiblement complexe car elle fait appel à des opérations élémentaires du type additions, soustractions ou multiplications.

L'invention a pour objet un procédé d'analyse d'un câble dans lequel un signal de référence s(t) de support temporel borné est injecté, caractérisé en ce qu'il comprend les étapes suivantes :

- Acquérir un signal r(t) de mesure caractéristique de la mesure de la réflexion dudit signal de référence s dans le câble,
- Identifier et sélectionner au moins un point dudit signal r de mesure correspondant à un passage du signal à une valeur nulle et dont l'abscisse est notée $t_0$,
- Générer, sur un intervalle temporel centré autour dudit au moins un point d'abscisse $t_0$, au moins un signal modifié z(t) à l'aide de la relation suivante $z(t_0+t) = r(t_0+t) - r(t_0-t)$,
- Identifier au moins un éventuel défaut sur le câble à partir de l'analyse dudit au moins un signal modifié z(t).

Selon une variante particulière, le procédé selon l'invention comprend en outre une étape de division dudit signal modifié par un facteur d'amplification C dépendant de l'intégration dudit signal r(t) de mesure sur une moitié dudit intervalle temporel.

Selon un aspect particulier de l'invention, le facteur d'amplification est égal à la valeur absolue de la moyenne ou de l'énergie dudit signal r(t) de mesure sur une moitié dudit intervalle temporel.

Selon une variante particulière, le procédé selon l'invention comprend en outre une étape de tri des points dudit signal r(t) de mesure correspondant à un passage du signal à une valeur nulle, la sélection d'un point étant réalisée en comparant une valeur représentative de l'énergie dudit signal r de mesure calculée au moins sur un intervalle temporel pris parmi un premier intervalle temporel dont la borne supérieure est égale à l'abscisse $t_0$ dudit point ou un second intervalle temporel dont la borne inférieure est égale à l'abscisse $t_0$ dudit point, à un seuil configuré au moins en fonction des caractéristiques du signal.

Selon un aspect particulier de l'invention, la sélection d'un point est réalisée en comparant une valeur représentative de l'énergie dudit signal r(t) de mesure calculée respectivement sur ledit premier intervalle temporel et sur ledit second intervalle temporel à un seuil configuré au moins en fonction des caractéristiques du signal.

Selon un aspect particulier de l'invention, ledit seuil est configuré en fonction du rapport signal à bruit.

Selon un aspect particulier de l'invention, le signal de référence s(t) injecté dans le câble est un signal impulsionnel et la durée de l'intervalle temporel centré autour dudit point d'abscisse $t_0$ est sensiblement égale au double de la largeur d'impulsion du signal de référence s.

Selon une variante particulière, le procédé selon l'invention comprend en outre une étape de recherche d'au moins un extremum du signal modifié z(t) indiquant la présence d'un défaut sur le câble.

L'invention a également pour objet un dispositif pour l'analyse d'un câble comprenant des moyens adaptés pour mettre en œuvre le procédé d'analyse selon l'invention.

L'invention a également pour objet un dispositif pour l'analyse d'un câble comprenant un appareil de mesure, en un point du câble, d'un signal réfléchi dans le câble et un calculateur configuré pour exécuter le procédé d'analyse selon l'invention.

L'invention a également pour objet un système de réflectométrie comprenant un dispositif pour l'analyse d'un câble selon l'invention et un dispositif d'injection, en un point du câble, d'un signal de référence.

L'invention a également pour objet un programme d'ordinateur comportant des instructions pour l'exécution du procédé d'analyse d'un câble selon l'invention, lorsque le programme est exécuté par un processeur.

L'invention a également pour objet un support d'enregistrement lisible par un processeur sur lequel est enregistré un programme comportant des instructions pour l'exécution du procédé d'analyse d'un câble selon l'invention, lorsque le programme est exécuté par un dispositif pour l'analyse d'un câble selon l'invention.

D'autres caractéristiques et avantages de la présente invention apparaîtront mieux à la lecture de la description qui suit en relation aux dessins annexés qui représentent :

- La figure 1, un organigramme illustrant les étapes du procédé d'analyse selon l'invention,
- La figure 2, un réflectogramme temporel représentant un exemple de signal de référence s et de signature r du signal réfléchi sur un défaut non franc,
- La figure 3, un exemple de comparaison entre un réflectogramme temporel obtenu avec et sans application de l'invention.
- La figure 4, un schéma d'un exemple de réalisation d'un dispositif d'analyse selon l'invention,

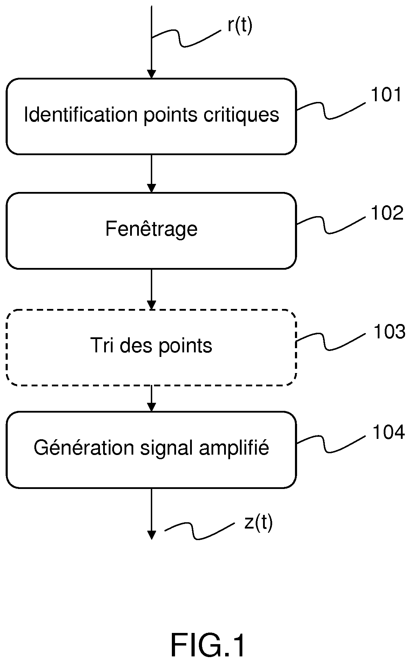

La figure 1 détaille sur un organigramme les étapes de mise en œuvre de l'invention selon un exemple de réalisation.

L'invention consiste en l'application d'un procédé de traitement de signal à une mesure de réflectométrie. Une telle mesure peut être obtenue en injectant un signal de référence s dans un câble en un point d'injection puis en mesurant la réflexion de ce signal, au même point d'injection ou en un point de mesure différent. Le signal s se propageant dans le câble rencontre des discontinuités d'impédance qui engendrent des réflexions. L'invention peut donc être appliquée directement sur une mesure r du signal réfléchi lorsque le signal de référence s injecté dans le câble est à support temporel borné et est du type signal impulsionnel. Par exemple, le signal s de référence peut consister en une impulsion Gaussienne mais aussi une impulsion du type triangulaire ou créneau.

L'invention ne se limite cependant pas à ce type de signaux et est applicable plus généralement à tout type de signaux de référence utilisés en réflectométrie. Par exemple, le signal de référence s peut aussi consister en une séquence numérique en bande de base du type STDR de l'acronyme anglais signifiant « Sequence time domain reflectometry » ou en un signal à étalement de spectre du type SSTDR de l'acronyme anglais « Spread Spectrum time domain reflectometry ». Dans ces deux derniers cas cependant, l'invention s'applique non pas directement à la mesure r du signal réfléchi mais à cette mesure intercorrélée avec le signal s injecté. Ce traitement préalable est nécessaire pour se ramener à un signal de type impulsionnel pour lequel les signatures des réflexions sur des discontinuités d'impédance ne présentent qu'un seul passage à zéro. Ce point sera explicité plus en détail par la suite.

De façon générale, la méthode selon l'invention peut inclure une étape d'injection d'un signal de référence dans le câble à tester puis une étape de mesure du signal réfléchi. Mais l'invention peut aussi être appliquée directement à une mesure de réflexion qui a été réalisée au préalable puis enregistrée sur un support de sauvegarde. L'invention peut aussi être appliquée sur un signal de mesure sur lequel a été appliqué un prétraitement, par exemple pour effectuer une première étape de débruitage ou pour recentrer la moyenne du signal sur une valeur nulle. L'Homme du métier saura sans difficultés étendre l'application de l'invention au-delà des exemples spécifiques décrits pour tout type de signaux caractéristiques d'une mesure de réflectométrie temporelle.

Le procédé de traitement de signal selon l'invention a pour but d'amplifier sélectivement les signatures des défauts non francs, c'est-à-dire des défauts de faible amplitude, sans amplifier les artefacts dus au bruit et sans amplifier non plus les signatures des défauts francs.

Le terme signature est utilisé ici pour désigner la portion de la mesure du signal réfléchi qui correspond à la réflexion du signal sur une discontinuité d'impédance.

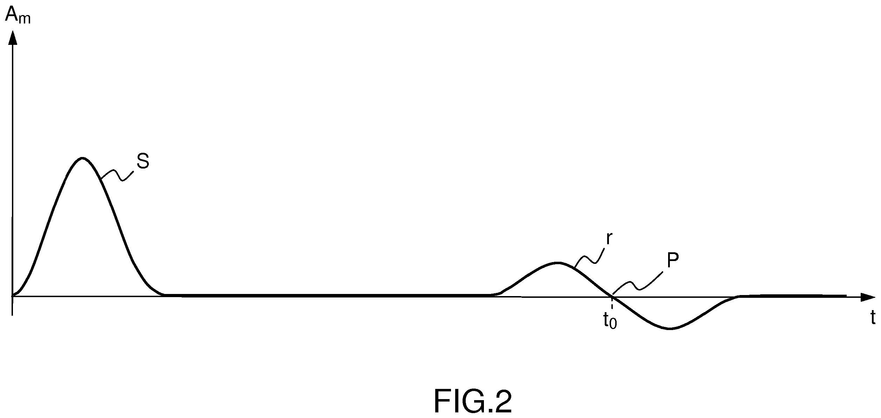

La figure 2 illustre un exemple de réflectogramme temporel sur lequel est représenté le signal de référence s, injecté dans le câble, qui présente une forme d'impulsion Gaussienne. Sur le même réflectogramme, est représentée la signature r de la réflexion de ce signal sur un défaut non franc. Cette signature r consiste en la superposition d'une impulsion d'amplitude positive et de la même impulsion d'amplitude négative. Cette forme particulière est due au fait que le signal incident se réfléchi une première fois sur l'interface correspondant au point d'entrée du défaut non franc, puis une seconde fois sur l'interface correspondant au point de sortie du défaut non franc, en supposant que le défaut présente une longueur non nulle sur le câble. Ce principe est bien connu du domaine des systèmes de réflectométrie temporelle appliqués au diagnostic de câbles ou lignes de transmission.

Sur l'exemple de la figure 2, l'amplitude de la signature r du défaut non franc est volontairement amplifiée pour des raisons de lisibilité. En réalité et selon la nature du défaut et son importance, l'amplitude de la signature r peut être très faible par rapport à l'amplitude du signal injecté. Par conséquent, sa détection et sa localisation peuvent poser problème notamment pour des défauts très superficiels du type éraflure de l'isolant du câble.

Selon une première étape 101 du procédé selon l'invention, on recherche des points critiques dans le signal r de mesure, ces points critiques correspondant à des passages à zéro du signal.

Sur l'exemple de la figure 2, on a identifié un tel point critique P d'abscisse temporelle $t_0$.

A l'issu de la première étape 101, on obtient un ensemble de points critiques avec leurs abscisses temporelles respectives.

Pour améliorer la précision de localisation des points critiques, un prétraitement préalable peut être appliqué pour corriger l'amplitude globale du signal d'un facteur permettant d'obtenir une moyenne du signal nulle, sur la portion de signal comprenant uniquement les signatures des défauts.

Un but de la première étape 101 est d'identifier les passages à zéro du signal qui correspondent à priori à des réflexions du signal sur des discontinuités d'impédance.

Dans une étape 102, on sélectionne, pour chaque point critique identifié, une portion du signal comprenant le point critique. La portion de signal est limitée à un intervalle temporel centré sur le point critique et de durée prédéterminée. Avantageusement, la durée de l'intervalle temporel est au moins égale au double de la durée de l'impulsion du signal de référence s. La portion de signal sélectionnée doit englober la signature du défaut associée au point critique.

Pour améliorer la précision de la première étape 101 de sélection des points critiques, il est possible d'ajouter une étape 103 de tri des points sélectionnés à l'étape 101. Cette étape a pour but d'éliminer les points critiques qui correspondent non pas à des signatures de défauts mais à du bruit de mesure.

Une mise en œuvre possible de l'étape 103 de tri des points critiques consiste à calculer, sur la durée de l'intervalle temporel sélectionné à l'étape 102, la moyenne du signal dans le sous-intervalle temporel des temps inférieurs à l'abscisse $t_0$ du point critique ou la moyenne du signal dans le sous-intervalle temporel des temps supérieurs à l'abscisse $t_0$ du point critique ou les deux à la fois. On compare ensuite la valeur absolue de l'une ou l'autre (ou des deux) moyenne(s) à un seuil de comparaison configuré en fonction de caractéristiques du signal et/ ou de l'application visée. Par exemple, le seuil peut dépendre du rapport signal à bruit. Si la valeur absolue de la moyenne (ou si la valeur absolue de chaque moyenne) dépasse le seuil de comparaison, on en déduit que la signature identifiée correspond bien à un défaut. Dans le cas contraire, on en déduit que le point critique identifié correspond à un artefact de mesure ou plus généralement à du bruit. Le seuil de comparaison est fixé à une valeur qui dépend des paramètres du signal injecté (son amplitude notamment) et d'autres paramètres liées aux caractéristiques du câble (son atténuation par exemple) ou aux caractéristiques des appareils de mesure utilisés. La valeur de seuil utilisée doit permettre de rejeter les points critiques correspondants au bruit et conserver les points critiques correspondant à des défauts. Cette valeur peut notamment être réglée en fonction de la résolution minimum de l'amplitude d'un défaut que l'on souhaite pouvoir détecter. L'Homme du métier saura, à l'aide de tests de routine, régler la valeur du seuil de comparaison en fonction du système visé.

Dans une autre étape 104, on génère, pour chaque signature de défaut sélectionnée, un signal modifié z(t) pour lequel les défauts non francs sont amplifiés.

Selon un premier mode de réalisation, le signal modifié peut être calculé à l'aide de la relation suivante :

$$z(t_0 + t) = r(t_0 + t) - r(t_0 - t) \quad (1)$$

pour t variant sur l'intervalle temporel sélectionné à l'étape 102. Par exemple si la durée de l'intervalle temporel est égale à T, t varie entre -T/2 et T/2.

La relation (1) liant z(t) et r(t) peut aussi s'écrire sous la forme :

$$z(t) = r(t) - r(2t_0 - t)$$

pour t variant entre $t_0$ - T/2 et $t_0$ + T/2

Le signal modifié à l'aide de la relation (1) permet d'une part d'amplifier l'amplitude d'un défaut lorsque sa signature est du type de celle décrite à la figure 2, c'est-à-dire la superposition d'une impulsion positive et d'une impulsion négative avec un point de symétrie au point d'abscisse $t_0$. D'autre part, la relation (1) permet également de supprimer la contribution du bruit si on suppose que celui est réparti aléatoirement dans l'intervalle.

Selon un second mode de réalisation, le signal z(t) calculé à l'aide de la relation (1) peut en outre être normalisé ou divisé par un facteur d'amplification supplémentaire C calculé à partir de l'intégrale du signal réfléchi r sur une durée égale à la moitié inférieure ou supérieure de l'intervalle.

$$C = \frac{1}{\frac{T}{2}} \left| \int_{t0-\frac{T}{2}}^{t0} r(t')dt' \right| = \frac{1}{\frac{T}{2}} \left| \int_{t0}^{t0+\frac{T}{2}} r(t')dt' \right| \quad (2)$$

Le terme de normalisation C correspond à la moyenne du signal réfléchi r(t) sur une durée T/2 ou encore à son énergie. Alternativement on peut remplacer le terme C par la puissance du signal réfléchi calculée sur la même durée.

Le signal modifié à l'étape 104 est ensuite donné par la relation z(t)=z(t)/C.

Cette étape de normalisation supplémentaire permet d'amplifier plus fortement les défauts non francs, c'est-à-dire les défauts de faible amplitude, sans amplifier les défauts francs et sans amplifier non plus les désadaptations d'impédances à l'entrée du câble ou à sa terminaison.

Les signaux modifiés z(t) générés pour chaque intervalle temporel associés à un défaut, permettent de reconstruire un réflectogramme complet en remplaçant uniquement, dans la mesure r du signal réfléchi, les portions de signaux associés aux intervalles temporels sélectionnés par les signaux modifiés z(t).

A partir du réflectogramme modifié obtenu, il est ensuite possible de caractériser un défaut, notamment un défaut non franc, par des techniques de traitement de signaux connues qui ne sont pas décrites ici. En synthèse, la recherche d'extremum dans le réflectogramme permet de localiser les défauts. La mesure de l'amplitude des signatures des défauts localisés permet d'estimer l'impédance caractéristique des défauts.

Le procédé selon l'invention permet une amplification sélective des signatures des défauts non francs sans amplification du bruit et par le biais d'un traitement reposant sur des opérations simples. L'invention est ainsi peu complexe à exécuter et est compatible d'implémentations sur des équipements de diagnostic embarqués.

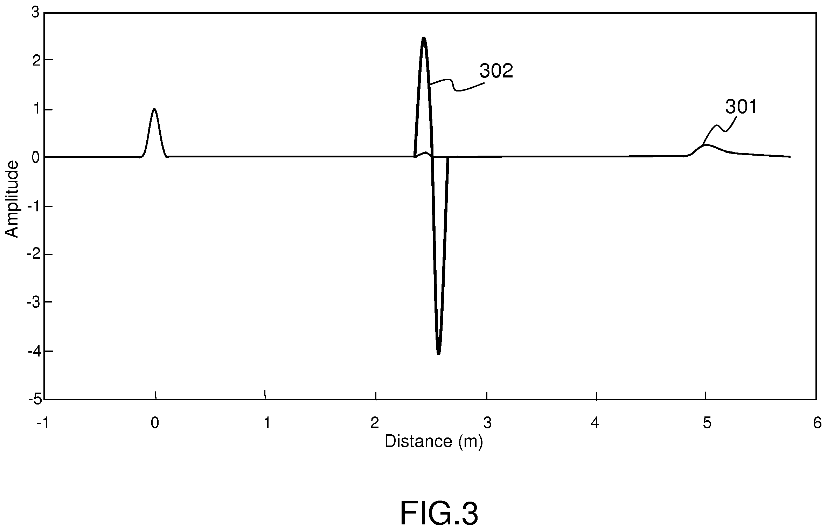

La figure 3 représente sur le même diagramme temporel, la mesure r 301 du signal réfléchi dans un câble présentant un défaut non franc à une distance d'environ 2,5 m de l'extrémité du câble et le signal amplifié 302 selon l'invention.

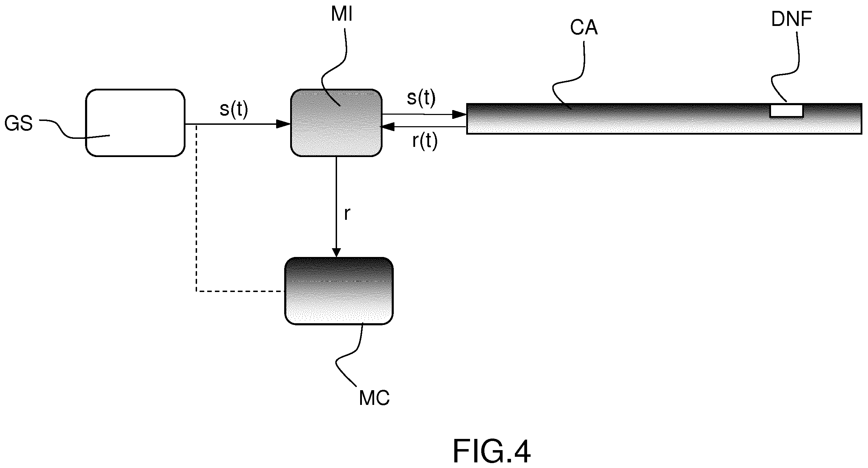

La figure 4 schématise, sur un synoptique, un exemple de système de réflectométrie apte à mettre en œuvre le procédé selon l'invention.

Un système de réflectométrie, ou réflectomètre, comporte au moins un générateur de signal GS, pour générer un signal de test s et l'injecter dans le câble à analyser CA qui comporte un défaut non franc DNF, un équipement de mesure MI pour mesurer le signal réfléchi r dans le câble CA et un composant électronique MC de type circuit intégré, tel un circuit à logique programmable, par exemple de type FPGA ou un micro-contrôleur, par exemple un processeur de signal numérique, qui reçoit la mesure du signal réfléchi r(t) et est configuré pour exécuter le procédé selon l'invention décrit à la figure 1 afin de produire un signal de mesure modifié z(t) dans lequel les défauts non francs sont amplifiés.

Le composant MC peut en outre exécuter d'autres traitements supplémentaires sur le signal modifié z(t) en vue de déterminer l'emplacement et les caractéristiques physiques des défauts impactant le câble CA, en particulier des défauts non francs.

Selon un mode de réalisation particulier, le signal de test s injecté peut également être fourni au composant MC lorsque les traitements réalisés nécessitent la connaissance du signal injecté, notamment lorsque ceux-ci incluent une étape d'intercorrélation entre le signal de test s et le signal réfléchi r.

L'injection du signal dans le câble et la mesure du signal réfléchi peuvent être réalisées par un seul et même composant mais aussi par deux composants distincts, notamment lorsque le point d'injection et le point de mesure sont dissociés.

Le système décrit à la figure 4 peut être mis en œuvre par une carte électronique sur laquelle sont disposés les différents composants. La carte peut être connectée au câble par un coupleur.

En outre, une unité de traitement, de type ordinateur, assistant numérique personnel ou autre dispositif électronique ou informatique équivalent peut être utilisé pour piloter le dispositif de réflectométrie et afficher les résultats des calculs effectués par le composant MC sur une interface homme-machine.

Le procédé selon l'invention peut être implémenté sur le composant MC à partir d'éléments matériels et/ou logiciels.

Le procédé selon l'invention peut être implémenté directement par un processeur embarqué ou dans un dispositif spécifique. Le processeur peut être un processeur générique, un processeur spécifique, un circuit intégré propre à une application (connu aussi sous le nom anglais d'ASIC pour « Application-Specific Integrated Circuit ») ou un réseau de portes programmables in situ (connu aussi sous le nom anglais de FPGA pour « Field-Programmable Gâte Array »). Le dispositif selon l'invention peut utiliser un ou plusieurs circuits électroniques dédiés ou un circuit à usage général. La technique de l'invention peut se réaliser sur une machine de calcul reprogrammable (un processeur ou un micro contrôleur par exemple) exécutant un programme comprenant une séquence d'instructions, ou sur une machine de calcul dédiée (par exemple un ensemble de portes logiques comme un FPGA ou un ASIC, ou tout autre module matériel).

Le procédé selon l'invention peut également être mis en œuvre exclusivement en tant que programme d'ordinateur, le procédé étant alors appliqué à une mesure de réflectométrie r préalablement acquise à l'aide d'un dispositif de réflectométrie usuel. Dans un tel cas, l'invention peut être mise en œuvre en tant que programme d'ordinateur comportant des instructions pour son exécution. Le programme d'ordinateur peut être enregistré sur un support d'enregistrement lisible par un processeur.

La référence à un programme d'ordinateur qui, lorsqu'il est exécuté, effectue l'une quelconque des fonctions décrites précédemment, ne se limite pas à un programme d'application s'exécutant sur un ordinateur hôte unique. Au contraire, les termes programme d'ordinateur et logiciel sont utilisés ici dans un sens général pour faire référence à tout type de code informatique (par exemple, un logiciel d'application, un micro logiciel, un microcode, ou toute autre forme d'instruction d'ordinateur) qui peut être utilisé pour programmer un ou plusieurs processeurs pour mettre en œuvre des aspects des techniques décrites ici. Les moyens ou ressources informatiques peuvent notamment être distribués ("*Cloud computing"),* éventuellement selon des technologies de pair-à-pair. Le code logiciel peut être exécuté sur n'importe quel processeur approprié (par exemple, un microprocesseur) ou cœur de processeur ou un ensemble de processeurs, qu'ils soient prévus dans un dispositif de calcul unique ou répartis entre plusieurs dispositifs de calcul (par exemple tels qu'éventuellement accessibles dans l'environnement du dispositif). Le code exécutable de chaque programme permettant au dispositif programmable de mettre en œuvre les processus selon l'invention, peut être stocké, par exemple, dans le disque dur ou en mémoire morte. De manière générale, le ou les programmes pourront être chargés dans un des moyens de stockage du dispositif avant d'être exécutés. L'unité centrale peut commander et diriger l'exécution des instructions ou portions de code logiciel du ou des programmes selon l'invention, instructions qui sont stockées dans le disque dur ou dans la mémoire morte ou bien dans les autres éléments de stockage précités.

L'invention s'applique pour le diagnostic de défauts superficiels sur tout type de câble ou ligne de transmission. En particulier l'invention s'applique à la surveillance de jonctions entre deux lignes de transmission dans des réseaux de câbles.

L'invention s'applique également à la surveillance de l'état de santé de structures autres que des câbles électriques. De telles structures peuvent inclure des éléments de ponts ou de murs pour l'industrie du bâtiment et des travaux publics ou encore un élément d'une aile d'avion, un fuselage ou encore une pale pour l'industrie aéronautique. Pour surveiller la détérioration localisée d'une structure, un principe consiste à positionner une ou plusieurs lignes de transmission à la surface de la structure et à appliquer un traitement par réflectométrie à chacune de ces lignes.

**Revendications**

1. Procédé d'analyse d'un câble dans lequel un signal de référence s(t) de support temporel borné est injecté, comprenant les étapes suivantes :

   - Acquérir un signal r(t) de mesure caractéristique de la mesure de la réflexion dudit signal de référence s dans le câble,
   - Identifier et sélectionner (101) au moins un point dudit signal r de mesure correspondant à un passage du signal à une valeur nulle et dont l'abscisse est notée $t_0$,
   le procédé étant **caractérisé en ce qu'**il comprend les étapes de :
   - Générer (104), sur un intervalle temporel (102) centré autour dudit au moins un point d'abscisse $t_0$, au moins un signal modifié z(t) à l'aide de la relation suivante $z(t_0+t) = r(t_0+t)- r(t_0-t)$,
   - Identifier au moins un éventuel défaut sur le câble à partir de l'analyse dudit au moins un signal modifié z(t).

2. Procédé d'analyse d'un câble selon la revendication 1 comprenant en outre une étape de division dudit signal modifié par un facteur d'amplification C dépendant de l'intégration dudit signal r(t) de mesure sur une moitié dudit intervalle temporel.

3. Procédé d'analyse d'un câble selon la revendication 2 dans lequel le facteur d'amplification est égal à la valeur absolue de la moyenne ou de l'énergie dudit signal r(t) de mesure sur une moitié dudit intervalle temporel.

4. Procédé d'analyse d'un câble selon l'une des revendications précédentes comprenant en outre une étape (103) de tri des points dudit signal r(t) de mesure correspondant à un passage du signal à une valeur nulle, la sélection d'un point étant réalisée en comparant une valeur représentative de l'énergie dudit signal r de mesure calculée au moins sur un intervalle temporel pris parmi un premier intervalle temporel dont la borne supérieure est égale à l'abscisse $t_0$ dudit point ou un second intervalle temporel dont la borne inférieure est égale à l'abscisse $t_0$ dudit point, à un seuil configuré au moins en fonction des caractéristiques du signal.

5. Procédé d'analyse d'un câble selon la revendication 4 dans lequel la sélection d'un point est réalisée en comparant une valeur représentative de l'énergie dudit signal r(t) de mesure calculée respectivement sur ledit premier intervalle temporel et sur ledit second intervalle temporel à un seuil configuré au moins en fonction des caractéristiques du signal.

6. Procédé d'analyse d'un câble selon l'une des revendications 4 ou 5 dans lequel ledit seuil est configuré en fonction du rapport signal à bruit.

7. Procédé d'analyse d'un câble selon l'une des revendications précédentes dans lequel le signal de référence s(t) injecté dans le câble est un signal impulsionnel et la durée de l'intervalle temporel (102) centré autour dudit point d'abscisse $t_0$ est sensiblement égale au double de la largeur d'impulsion du signal de référence s.

8. Procédé d'analyse d'un câble selon l'une des revendications précédentes dans lequel ledit procédé comporte en outre une étape de recherche d'au moins un extremum du signal modifié z(t) indiquant la présence d'un défaut sur le câble.

9. Dispositif pour l'analyse d'un câble (CA) comprenant des moyens (MC) adaptés pour mettre en œuvre le procédé d'analyse selon l'une quelconque des revendications 1 à 8.

10. Système de réflectométrie comprenant un dispositif pour l'analyse d'un câble selon la revendication 9 et un dispositif d'injection (GS), en un point du câble, d'un signal de référence.

11. Programme d'ordinateur comportant des instructions pour l'exécution du procédé d'analyse d'un câble selon l'une quelconque des revendications 1 à 8, lorsque le programme est exécuté par le dispositif selon la revendication 9.

12. Support d'enregistrement lisible par un processeur sur lequel est enregistré un programme d'ordinateur selon la revendication 11.

**Patentansprüche**

1. Verfahren zum Analysieren eines Kabels, in das ein zeitlich begrenztes Referenzträgersignal s(t) eingespeist wird, das die folgenden Schritte umfasst:

   - Erfassen eines Messsignals r(t), das charakteristisch für die Messung der Reflexion des Referenzsignals s im Kabel ist,
   - Identifizieren und Auswählen (101) mindestens eines Punkts des Messsignals r, der einem Nulldurchgang des Signals entspricht und dessen Abszisse mit $t_0$ bezeichnet ist,
   wobei das Verfahren **dadurch gekennzeichnet ist, dass** es die folgenden Schritte beinhaltet:
   - Erzeugen (104), in einem um den mindestens einen Abszissenpunkt $t_0$ zentrierten Zeitintervall (102), mindestens eines modifizierten Signals z(t) mit Hilfe der folgenden Beziehung $z(t_0+t) = r(t_0+t)- r(t_0-t)$,
   - Identifizieren mindestens eines eventuellen Defekts am Kabel auf der Basis der Analyse des mindestens einen modifizierten Signals z(t).

2. Verfahren zum Analysieren eines Kabels nach Anspruch 1, das ferner einen Schritt des Dividierens des modifizierten Signals durch einen Verstärkungsfaktor C beinhaltet, der von der Integration des Messsignals r(t) über eine Hälfte des Zeitintervalls abhängt.

3. Verfahren zum Analysieren eines Kabels nach Anspruch 2, wobei der Verstärkungsfaktor gleich dem Absolutwert des Mittelwertes oder der Energie des Messsignals r(t) über eine Hälfte des Zeitintervalls ist.

4. Verfahren zum Analysieren eines Kabels nach einem der vorhergehenden Ansprüche, das ferner einen Schritt (103) des Sortierens von Punkten des Messsignals r(t) beinhaltet, die einem Nulldurchgang des Signals entsprechen, wobei die Auswahl eines Punktes durch Vergleichen eines für die Energie des Messsignals r repräsentativen Wertes, berechnet zumindest über ein Zeitintervall, das ausgewählt wird aus einem ersten Zeitintervall, dessen obere Grenze gleich der Abszisse $t_0$ des Punktes ist, oder einem zweiten Zeitintervall, dessen untere Grenze gleich der Abszisse $t_0$ des Punktes ist, mit einem Schwellenwert erfolgt, der zumindest in Abhängigkeit von den Kennwerten des Signals konfiguriert wird.

5. Verfahren zum Analysieren eines Kabels nach Anspruch 4, bei dem die Auswahl eines Punktes durch Vergleichen eines über das erste Zeitintervall bzw. das zweite Zeitintervall berechneten, für die Energie des Messsignals r(t) repräsentativen Wertes mit einem Schwellenwert erfolgt, der zumindest in Abhängigkeit von den Kennwerten des Signals konfiguriert wird.

6. Verfahren zum Analysieren eines Kabels nach Anspruch 4 oder 5, wobei der Schwellenwert in Abhängigkeit vom Signal-Rausch-Verhältnis konfiguriert wird.

7. Verfahren zum Analysieren eines Kabels nach einem der vorhergehenden Ansprüche, bei dem das in das Kabel eingespeiste Referenzsignal s(t) ein Impulssignal ist und die Dauer des um den Abszissenpunkt $t_0$ zentrierten Zeitintervalls (102) im Wesentlichen das Doppelte der Impulsbreite des Referenzsignals s beträgt.

8. Verfahren zum Analysieren eines Kabels nach einem der vorhergehenden Ansprüche, wobei das Verfahren ferner einen Schritt des Suchens mindestens eines Extremwertes des modifizierten Signals z(t) beinhaltet, der das Vorliegen eines Fehlers auf dem Kabel anzeigt.

9. Gerät zum Analysieren eines Kabels (CA), das Mittel (MC) umfasst, die zum Durchführen des Analyseverfahrens nach einem der Ansprüche 1 bis 8 ausgelegt sind.

10. Reflektometriesystem, das ein Gerät zum Analysieren eines Kabels nach Anspruch 9 und ein Gerät (GS) zum Einspeisen eines Referenzsignals an einem Punkt des Kabels umfasst.

11. Computerprogramm mit Befehlen zum Durchführen des Verfahrens zum Analysieren eines Kabels nach einem der Ansprüche 1 bis 8, wenn das Programm von dem Gerät nach Anspruch 9 ausgeführt wird.

12. Prozessorlesbares Aufzeichnungsmedium, auf dem ein Computerprogramm nach Anspruch 11 aufgezeichnet ist.

**Claims**

1. A method for analyzing a cable into which a reference signal s(t) of bounded temporal support is injected, comprising the following steps:

   - Acquiring a measurement signal r(t) characteristic of the measurement of the reflection of said reference signal s in the cable,
   - Identifying and selecting (101) at least one point of said measurement signal r corresponding to when the signal crosses a zero value and whose abscissa is denoted $t_0$,
   said method being **characterized in that** it comprises the following steps:
   - Generating (104), over a time interval (102) centered around said at least one point with abscissa $t_0$, at least one modified signal z(t) with the aid of the following relation $z(t_0+t) = r(t_0+t)-r(t_0-t)$,
   - Identifying at least one possible fault on the cable on the basis of the analysis of said at least one modified signal z(t).

2. The method for analyzing a cable as claimed in claim 1, further comprising a step of dividing said modified signal by an amplification factor C dependent on the integration of said measurement signal r(t) over a half of said time interval.

3. The method for analyzing a cable as claimed in claim 2, in which the amplification factor is equal to the absolute value of the average or of the energy of said measurement signal r(t) over a half of said time interval.

4. The method for analyzing a cable as claimed in one of the preceding claims, further comprising a step (103) of sorting the points of said measurement signal r(t) corresponding to when the signal crosses a zero value, the selection of a point being carried out by comparing a value representative of the energy of said measurement signal r, calculated at least over a time interval taken from among a first time interval whose upper bound is equal to the abscissa $t_0$ of said point or a second time interval whose lower bound is equal to the abscissa $t_0$ of said point, with a threshold configured at least as a function of the characteristics of the signal.

5. The method for analyzing a cable as claimed in claim 4, in which the selection of a point is carried out by comparing a value representative of the energy of said measurement signal r(t), calculated respectively over said first time interval and over said second time interval, with a threshold configured at least as a function of the characteristics of the signal.

6. The method for analyzing a cable as claimed in one of claims 4 or 5, in which said threshold is configured as a function of the signal-to-noise ratio.

7. The method for analyzing a cable as claimed in one of the preceding claims, in which the reference signal s(t) injected into the cable is an impulse signal and the duration of the time interval (102) centered around said point with abscissa $t_0$ is substantially equal to twice the pulse width of the reference signal s.

8. The method for analyzing a cable as claimed in one of the preceding claims, in which said method further comprises a step of searching for at least one extremum of the modified signal z(t) indicating the presence of a fault on the cable.

9. A device for the analysis of a cable (CA) comprising means (MC) adapted to implement the analysis method as claimed in any one of claims 1 to 8.

10. A reflectometry system comprising a device for the analysis of a cable as claimed in claim 9 and a device (GS) for injecting, at a point of the cable, a reference signal.

11. A computer program comprising instructions for the execution of the method for analyzing a cable as claimed in any one of claims 1 to 8, when the program is executed by the device as claimed in claim 9.

12. A recording medium readable by a processor on which is recorded a program as claimed in claim 11.

r(t)

```
┌──────────────────────────────────────┐
│                                      │
│     Identification points critiques  │ ⌇ 101
│                                      │
└──────────────────────────────────────┘
                  │
                  ▼
┌──────────────────────────────────────┐
│                                      │
│              Fenêtrage               │ ⌇ 102
│                                      │
└──────────────────────────────────────┘
                  │
                  ▼
┌ ─ ─ ─ ─ ─ ─ ─ ─ ─ ─ ─ ─ ─ ─ ─ ─ ─ ─ ┐
                                        
│            Tri des points            │ ⌇ 103
                                        
└ ─ ─ ─ ─ ─ ─ ─ ─ ─ ─ ─ ─ ─ ─ ─ ─ ─ ─ ┘
                  │
                  ▼
┌──────────────────────────────────────┐
│                                      │
│       Génération signal amplifié     │ ⌇ 104
│                                      │
└──────────────────────────────────────┘
                  │
                  ▼
```

z(t)

# FIG.1

FIG.2

FIG.3

FIG.4

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- FR 2981752

- FR 2946149

**Littérature non-brevet citée dans la description**

- **Y. J. SHIN.** Theory and Application of Time-Frequency Analysis to Transient Phenomena. *Electric Power and Other Physical Systems,* 2004